# FASCICULE DE BREVET EUROPEEN

(11) **EP 2 169 736 B1**
(45) Date de publication et mention de la délivrance du brevet: **29.08.2012**
(21) Numéro de dépôt: 09169695.5
(22) Date de dépôt: 08.09.2009
(51) Int. Cl.: H02N 2/18

(54) **Transducteur à polymère électroactif**
Signalwandler mit elektroaktivem Polymer
Transducer with electroactive polymer

(30) Priorité: 26.09.2008 FR 0856489
(43) Date de publication de la demande: 31.03.2010
(73) Titulaire: Commissariat à l'Énergie Atomique et aux Énergies Alternatives, 75015 Paris (FR)
(72) Inventeur: Jean-Mistral, Claire, 38000 GRENOBLE (FR); Chaillout, Jean-Jacques, 38960 SAINT ETIENNE DE CROSSEY (FR); Despesse, Ghislain, 38120 SAINT EGREVE (FR)
(74) Mandataire: de Beaumont, Michel

(56) Documents cités:
- WO-A-01/86695
- WO-A-02/37660
- WO-A-03/028122
- US-B1- 7 034 432
- BROOK M G: "RECENT DEVELOPMENTS IN ELECTRO-ACTIVE POLYMERA" PLASTICS AND RUBBER PROCESSING AND APPLICATIONS, APPLIED SCIENCE PUBLISHERS, LONDON, GB, vol. 8, no. 4, 1 janvier 1987 (1987-01-01), pages 235-238, XP009052870 ISSN: 0144-6045

## Description

### Domaine de l'invention

La présente invention concerne de façon générale les systèmes de transformation d'une déformation mécanique en une énergie électrique et vice versa en utilisant des polymères électroactifs. L'invention concerne plus particulièrement la réalisation d'un transducteur souple à base de polymère diélectrique capable de transformer une élongation mécanique qu'il subit en énergie électrique.

### Exposé de l'art antérieur

Des structures souples déformables capables de transformer une déformation mécanique qu'elles subissent en une énergie électrique et inversement font appel à des polymères électroactifs, et plus particulièrement aux polymères diélectriques. Typiquement, un film polymère forme le diélectrique d'un élément capacitif variable et est pris en sandwich entre deux électrodes souples. L'ensemble forme une structure électroactive dont les déformations (étirement/rétractation) se traduisent par une modification de surface et d'épaisseur qui engendre une variation de la capacité de l'élément réalisé. Le mouvement de l'objet ou des objets auxquels est attachée la structure lui permet d'occuper deux états (un étiré et un rétracté). Cette variation se traduit par deux valeurs distinctes de la capacité de la structure. L'application d'une tension de polarisation donnée lorsque la structure est contractée en épaisseur se traduit, lors de son étirement en épaisseur, par une diminution des charges dans le diélectrique sous l'effet de la diminution de la capacité (Q = CV). Des charges sont transférées de la structure vers une unité de stockage. L'énergie qui en résulte peut être récupérée par un système approprié. Différentes cycles sont envisageables dont les plus connus sont les cycles à champ électrique constant, à charge constante ou à tension constante. Les cycles électriques de charge et de décharge sont synchronisés, par un circuit de gestion électrique adapté, sur ces deux états de déformation de la membrane permettant la récupération d'énergie (récupération électrostatique).

De telles structures sont susceptibles d'être utilisées pour convertir une déformation d'un objet sous l'effet de contraintes extérieures (par exemple un textile, un grillage, un filet de pêche, le tamis d'une raquette de tennis, la voile d'un navire, etc.) ou convertir l'énergie mécanique au niveau d'une liaison entre deux éléments rigides en mouvement l'un par rapport à l'autre (par exemple joints de dilatation, amortisseurs, charnières, etc.) en énergie électrique.

Ces structures peuvent être également utilisées pour détecter des déformations locales dans une fonction de capteur.

Pour un fonctionnement correct, la membrane électroactive est généralement attachée en au moins deux points au système provoquant la déformation.

Diverses solutions sont décrites, par exemple, dans les brevets américains 6 768 246 et 7 034 432.

Une difficulté réside dans la limitation des contraintes mécaniques susceptibles d'être appliquées à la structure. En effet, des contraintes trop importantes peuvent provoquer la rupture de la membrane électroactive.

Une autre difficulté est de rendre le plus uniforme possible la déformation dans la zone active pour homogénéiser l'usure de la structure et optimiser la récupération d'énergie pour un encombrement donné.

Les polymères électroactifs, plus particulièrement les polymères diélectriques, sont très utilisés en mode actionneur en tant que muscles artificiels. Une tension est appliquée à la structure qui se déforme jusqu'à un état d'équilibre entre force mécanique et électrique développées au sein de ladite structure. Il peut également être utile de limiter les déformations subies par le polymère pour éviter une rupture mécanique de la membrane ou uniformiser les déformations afin d'obtenir un mouvement plus régulier (par exemple, plus fluide). Classiquement, on diminue la tension électrique appliquée au polymère pour diminuer son étirement mécanique.

Le document WO-01/86695 décrit un réseau de transducteurs piézoélectriques dans lequel un unique film piézoélectrique présente une pluralité de régions alternativement concaves et convexes. Le film est relié à un support rigide qui délimite, par sa forme, les déformations qu'est susceptible de subir le film.

### Résumé

La présente invention vise à pallier tout ou partie des inconvénients des structures souples à base de polymère électroactif et en particulier diélectrique.

L'invention vise plus particulièrement à uniformiser les déformations subies par la portion active de la structure (polymère électroactif et électrodes).

Un autre mode de réalisation de la présente invention vise à optimiser la récupération d'énergie dans la structure.

Pour atteindre ces objets il est présenté un transducteur à polymère électroactif tel que défini par la révendicatin 1.

Selon un mode de réalisation du transducteur, les électrodes prennent la membrane en sandwich.

Selon un mode de réalisation du transducteur, les électrodes sont d'un même côté de la membrane.

Selon un mode de réalisation du transducteur, l'élément limiteur subit des déformations non coplanaires aux déformations de la membrane.

Selon un mode de réalisation du transducteur, deux supports sont dans le plan de la membrane et sont approximativement perpendiculaires à l'élément limiteur.

Selon un mode de réalisation du transducteur, la membrane est encadrée par une zone non active.

Selon un mode de réalisation du transducteur, ladite zone n'est pas déformable dans la direction de déformation de la membrane.

Selon un mode de réalisation du transducteur, plusieurs éléments limiteurs parallèles entre eux sont prévus.

Selon un mode de réalisation du transducteur, les serpentins formés par les éléments limiteurs sont dans des plans perpendiculaires au plan de la membrane.

Selon un mode de réalisation du transducteur, les éléments limiteurs et les supports sont une seule et même pièce formant un cadre autour de la membrane.

Selon un mode de réalisation du transducteur, plusieurs membranes sont superposées et partagent de mêmes supports et éléments limiteurs.

Selon un mode de réalisation du transducteur, l'élongation du serpentin est limitée par des éléments de butée.

Il est également prévu un système de récupération d'énergie d'un étirement mécanique, comportant au moins un transducteur et un circuit électronique de gestion de la charge et de la décharge du transducteur.

Il est également prévu un système actionneur comportant un circuit électronique de génération d'un champ électrique et au moins un transducteur tel que décrit ci-dessus.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est un schéma-blocs simplifié d'un mode de réalisation d'un système de récupération d'énergie du type auquel s'applique la présente invention ;
la figure 2A est une vue de dessus d'une structure souple usuelle ;
la figure 2B est une vue partielle en coupe d'une membrane électroactive ;
la figure 3 est une vue en perspective simplifiée d'un mode de réalisation d'une structure à polymère électroactif ;
les figures 4A et 4B sont des coupes de la structure de la figure 3, respectivement en position rétractée et étirée ;
les figures 4C et 4D sont des vues de dessus correspondant aux figures respectives 4A et 4B ;
la figure 5 est une vue en perspective d'un autre mode de réalisation d'une structure à polymère électroactif ;
la figure 6 est une vue en perspective d'encore un autre mode de réalisation d'une structure à polymère électroactif ;
la figure 7 est une vue de dessus d'encore un autre mode de réalisation d'une structure à polymère électroactif ; et
la figure 8 est un schéma électrique simplifié d'un circuit de commande et de synchronisation d'une structure à polymère électroactif.

De mêmes éléments ont été désignés par de mêmes références aux différentes figures.

### Description détaillée

Par souci de clarté, seuls les éléments utiles à la compréhension de l'invention ont été représentés et seront décrits. En particulier, l'obtention de membranes en polymère électroactif et des électrodes de collecte d'énergie n'a pas été détaillée, l'invention étant compatible avec les structures usuelles. De plus, la destination de l'énergie récupérée par les structures décrites n'a pas non plus été détaillée, l'invention étant là encore compatible avec les applications usuelles.

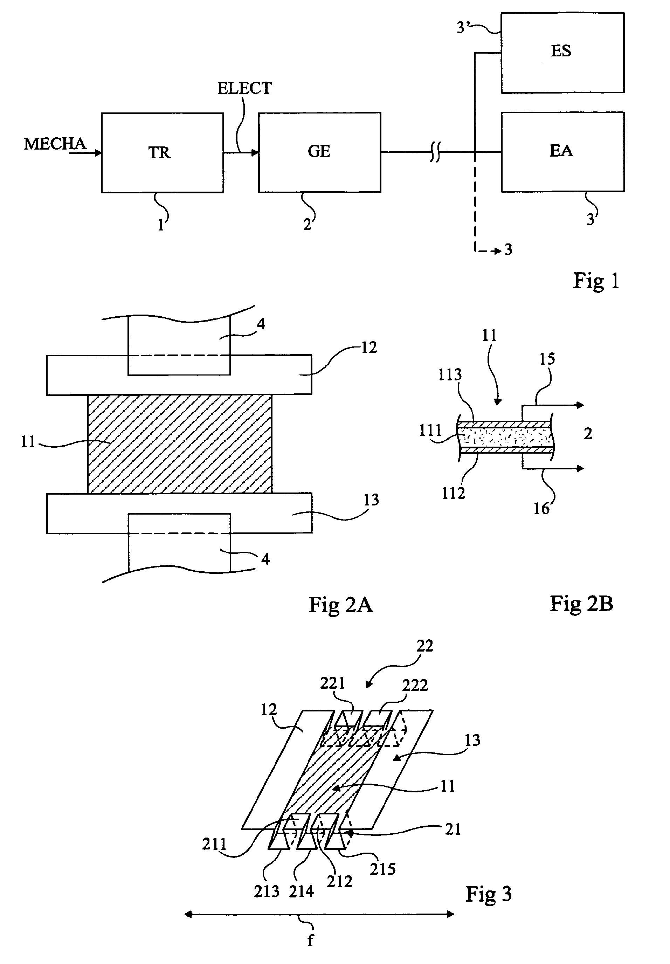

La figure 1 est un schéma-blocs fonctionnel illustrant un mode de réalisation d'un système de récupération d'énergie.

Une structure 1 (TR) à polymère électroactif est susceptible de subir une contrainte mécanique MECHA qui est convertie en énergie électrique ELECT. L'énergie électrique ELECT obtenue est mise en forme par un circuit de gestion électrique (bloc 2, GE) et est utilisée par une ou plusieurs applications électriques 3 (EA) ou est stockée au sein d'un élément de stockage 3' (ES) type pile, batterie, capacité. Pour une structure fonctionnant en mode actionneur, l'application d'un champ électrique engendre une déformation de la structure.

Les figures 2A et 2B sont respectivement une vue de dessus et une vue en coupe partielle d'une structure à polymère électroactif usuelle. Une membrane 11, formée d'un polymère électroactif 111 (figure 2B) encadré par deux électrodes 112 et 113 destinées à être reliées à un circuit de conversion électrique (2, figure 1), est maintenue à deux extrémités par des supports rigides 12 et 13. Ces supports sont dits rigides car ils doivent maintenir le polymère approximativement plan, surtout s'il est précontraint. Le module d'Young des supports est généralement 1000 fois supérieur à celui du polymère. Ces supports 12 et 13 sont, dans l'exemple de la figure 2, attachés à des éléments 4 liés à l'objet fournissant la contrainte mécanique de manière à favoriser une sollicitation principale. Toutefois, une pièce de liaison (non représentée) peut être intercalée entre les supports 12 et 13 et l'élément 4 de liaison pour donner plus de degrés de liberté à la structure.

La membrane 11 peut être fixée à son support par tout moyen adapté, par exemple, être collée par ses extrémités aux supports, être clipsée entre les supports et une pièce de renfort, etc.

Les électrodes 111 et 112 sont, par exemple, des couches de graisse conductrice de carbone ou d'argent auxquelles sont raccordés des fils ou pistes conductrices 15 et 16, ou autre moyen de conduction adapté à l'objet, vers l'électronique de commande 2.

La membrane 11 suit des mouvements de l'objet à laquelle elle est attachée en subissant essentiellement des sollicitations de type traction-compression qu'autorisent les liaisons entre la structure récupératrice et le ou les objets en mouvement ou en déformation. Il existe généralement une direction de déformation privilégiée pour les sollicitations utiles. De par sa souplesse et les liaisons mises en place entre la structure et l'objet, les sollicitations composées ou même la torsion sont autorisées mais non principales.

La figure 3 est une vue simplifiée en perspective d'un mode de réalisation d'une structure à polymère électroactif.

Par rapport à la structure des figures 2A et 2B, les deux supports rigides 12 et 13 sont reliés l'un à l'autre par des éléments limiteurs 21 et 22 de l'étirement qu'est susceptible de subir la membrane active 11. Les supports 12 et 13 et les limiteurs 21 et 22 peuvent former une seule et même pièce ou plusieurs pièces attachées entre elles de manière à ce que la structure soit la plus coplanaire possible et possède les propriétés mécaniques escomptées. Les limiteurs 21 et 22 sont de préférence positionnés dans la troisième dimension par rapport au plan de la structure. Dans cet exemple, ils sont disposés latéralement par rapport à la membrane 11 et ont une forme de serpentin dans des plans perpendiculaires au plan de la membrane 11. Les serpentins sont ici constitués de tronçons rectilignes mais pourront avoir tout autre forme (par exemple, sinusoïdale, triangulaire, etc.). La membrane 11 est attachée à des portions ou points des serpentins qui sont présents dans son plan. De préférence, la répartition des points d'attache (par collage, clipsage, etc.) est régulière sur la longueur des limiteurs.

En figure 3, les supports 12 et 13, la membrane 11 et des tronçons supérieurs 211, 212, 221 et 222 des limiteurs 21 et 22 sont approximativement coplanaires.

La largeur et la nature des limiteurs 21 et 22 dans le plan de la membrane dépendent du matériau constitutif de ces limiteurs, et de la résistance mécanique souhaitée.

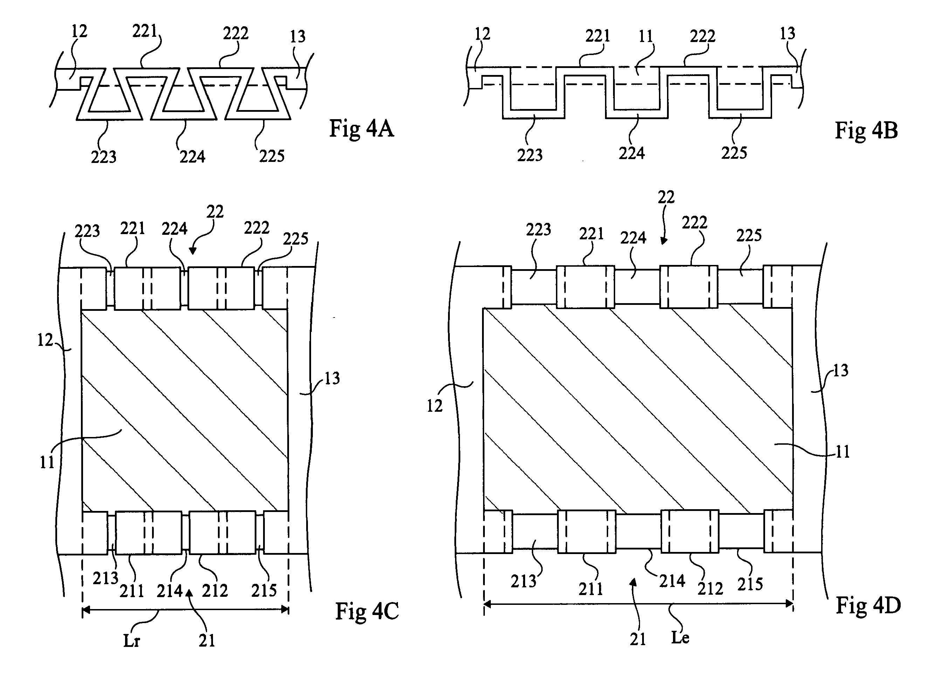

Les figures 4A et 4B sont des coupes schématiques de la structure de la figure 3, respectivement en position contractée et en position étirée. Les limiteurs passent d'une position de repos (figure 4A) à une position étirée (figure 4B). Ces limiteurs sont déformables et en forme de serpentin.

Les figures 4C et 4D sont des vues de dessus correspondantes.

En position comprimée (figures 4A et 4C), les méandres des limiteurs 21 et 22 suivent, en section, des tracés approximativement triangulaires et les tronçons parallèles au plan de la membrane 11 (tronçons supérieurs 211, 212, 221, 222 et inférieurs 213, 214, 215, 223, 224, 225) sont rapprochés les uns des autres dans leurs plans respectifs.

Sous l'effet d'une traction sur les éléments supports 12 et 13 dans le sens de la flèche f (figure 3), la structure est étirée dans cette direction. Les éléments limiteurs 21 et 22 se déforment (de la forme illustrée en figure 4A vers celle illustrée en figure 4B) jusqu'à une forme limite préétablie. Une fois cette forme géométrique atteinte, les limiteurs 21 et 22 ne se déforment plus et préservent cette forme géométrique tant que l'effet de la traction est présent. Ainsi, ils limitent l'étirement possible de la membrane et minimisent les risques de rupture mécanique. En outre, les éléments limiteurs 21 et 22 procurent une rigidité supplémentaire contre des sollicitations parasites (torsions) que pourrait subir la structure et favorisent ainsi la déformation de la structure dans sa ou ses directions principales.

En position étirée (figures 4B et 4D), les méandres du serpentin ont, par exemple, une forme approximativement rectangulaire, les tronçons parallèles au plan de la structure étant plus écartés les uns des autres dans leurs plans respectifs.

Comme l'illustre la figure 4D, la surface de la membrane 11 (correspondant ici à la partie active) est plus importante qu'en figure 4C. La capacité est donc supérieure. L'état étiré maximal correspond à la capacité maximale de la structure alors que l'état le plus comprimé correspond à la capacité minimale. L'étirement possible Le-Lr, donc la course des limiteurs 21 et 22, est choisi en fonction de l'étirement possible de la membrane 11.

Les éléments limiteurs constituent des ressorts mécaniques hors plan par rapport à la membrane déformable. Utiliser la troisième dimension permet, entre autres, d'optimiser la surface active de la membrane, donc l'énergie récupérée, pour un encombrement en surface donné. En effet, pour une surface donnée, la membrane reste approximativement rectangulaire alors que les solutions connues exploitent une déformation trapézoïdale de la membrane qui est plus encombrante.

Le cas échéant, la membrane peut être précontrainte lors de la pose des éléments limiteurs, avec un étirement minimal correspondant à la longueur minimale (contractée) des éléments limiteurs.

Plus le nombre de dents ou de méandres du serpentin est élevé, plus le nombre de points d'accroche de la membrane est élevé et plus la déformation dans la zone active peut être répartie uniformément et moins la membrane se fragilise. Les figures 4A à 4D illustrent un mode de réalisation dans lequel les tronçons des éléments limiteurs sont de longueur constante et ne changent que de forme. Ils sont, par exemple, en polymère rigide de type thermoplastique, thermodurcissable avec un module de Young supérieur à celui de la membrane et une capacité d'élongation inférieure à celle de la membrane. En variante, le matériau constitutif des éléments limiteurs est un élastomère, plus élastique que les matériaux précédemment cités et qui autorise une déformation (élongation) des méandres. Cette capacité d'élongation reste inférieure à celle de la membrane, mais favorise l'uniformité de la déformation subie par la membrane. Selon une autre variante, les tronçons horizontaux sont déformables en longueur alors que les liaisons entre les tronçons supérieurs et inférieurs ne sont pas déformées. Ces variantes sont bien entendu combinables.

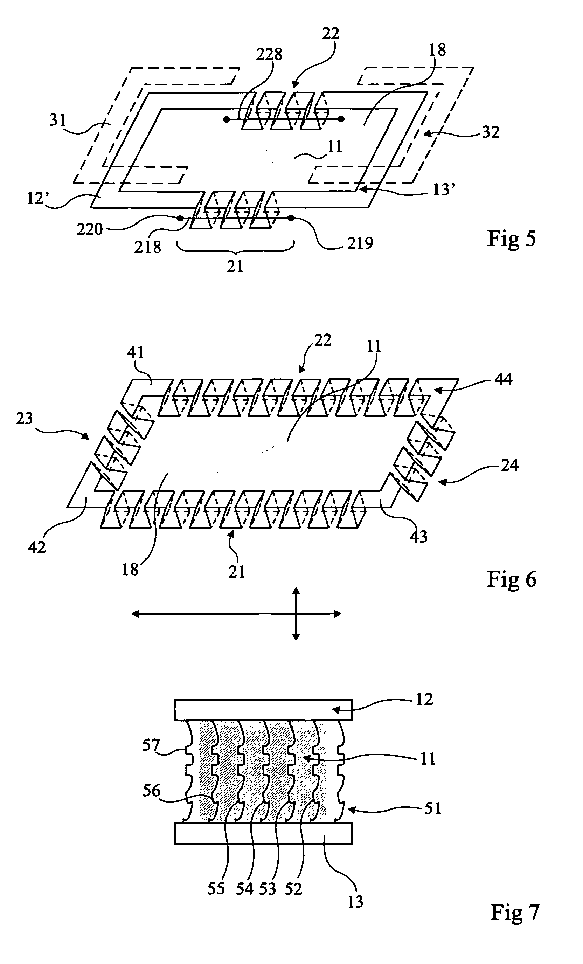

La figure 5 est une vue en perspective schématique d'un autre mode de réalisation dans lequel la membrane active 11 de la structure ne couvre pas l'intégralité de la surface entre les supports. Par exemple, la surface des électrodes est inférieure à la surface du film polymère. Selon un autre exemple, le sandwich polymère-électrodes est prolongé de part et d'autre dans le sens de la déformation, par une zone 18 en un matériau qui peut être différent. Dans ce dernier cas, ce matériau est de préférence non déformable dans le sens de l'élongation afin de concentrer et augmenter les déformations dans la zone pour optimiser le rendement. Dans l'exemple de la figure 5, la zone inactive 18 est du même matériau que la membrane 11 autour de la zone active et est reliée ponctuellement aux éléments limiteurs. On peut aussi considérer que l'ensemble membrane 11 - zone 18 forme la membrane électroactive dont seule une portion centrale 11 est active.

La figure 5 illustre également une variante selon laquelle l'étirement du serpentin, formant l'élément limiteur, est lui-même limité par une tige ou un fil 218, respectivement 228 traversant ses méandres parallèlement à sa direction principale. Dans l'exemple de la figure 5, la tige 228 limite l'élongation du serpentin en ses extrémités par deux butées (par exemple, des billes 219 et 220). Le serpentin ne peut s'étirer que de la longueur de la tige ou fil 218 et 228. On peut envisager des butées entre chaque méandre pour forcer la répartition des déformations. On peut aussi envisager un serpentin avec des méandres ouverts, c'est-à-dire sans les tronçons 223 à 225 (respectivement 213 à 215), la tige 228 (respectivement 218) assurant la liaison avec le reste de la structure tout en limitant l'étirement. Utiliser une tige, un fil ou autre élément de butée pour limiter l'élongation du serpentin permet de pallier des tolérances de fabrication des serpentins, notamment des tolérances dans les longueurs respectives des différents tronçons.

En outre, les éléments supports 12' et 13' ont une forme adaptée à la taille de la membrane 11. Par exemple, chacun a une forme de U dont les extrémités sont reliées aux extrémités de l'autre élément par un limiteur. Les supports et les limiteurs peuvent aussi former une seule pièce, pourvu que le serpentin limiteur soit situé au niveau de la partie active 11.

La figure 5 illustre une autre variante selon laquelle des éléments de renfort 31 et 32 sont rapportés sur la structure. En figure 5, ces éléments 31 et 32 servent à pincer la membrane électroactive 11-18. Ils peuvent aussi avoir un rôle d'attache de la zone 18 ou servir à rigidifier la structure pour maintenir sa forme plane.

Toutefois, les limiteurs ne sont pas nécessairement situés latéralement par rapport à la structure.

La figure 6 représente un autre mode de réalisation dans lequel des éléments limiteurs 21 à 24 sont prévus dans les quatre directions de la membrane 11. Un tel mode de réalisation est plus particulièrement destiné au cas où la membrane est susceptible d'être étirée/déformée dans plusieurs directions. Les coins 41, 42, 43 et 44 de la structure constituent les éléments support qui vont être reliés à l'objet initiant les déformations. La membrane 11 peut occuper tout l'espace entre les limiteurs ou, comme cela est représenté, être encadrée par une zone souple inactive 18. Dans ce cas, la zone 18 est déformable dans toutes les directions.

Aux figures 3 à 6, les éléments limiteurs ont été représentés comme des prolongements des supports. En pratique, ils seront souvent en un matériau différent pour leur conférer la capacité de se déformer. En particulier, les éléments limiteurs pourront également avoir une fonction ressort. Dans certains cas, en particulier si la zone 18 est précontrainte, le limiteur peut servir de point d'ancrage du polymère et garantir la forme plane et rectangulaire de la structure.

La figure 7 illustre une variante de réalisation dans laquelle plusieurs éléments limiteurs 51 à 57, répartis perpendiculairement à la direction de déformation, relient les deux supports de la zone active. Ces éléments limiteurs sont, par exemple, des fils d'un objet tissé qui sont prévus avec une longueur initiale supérieure à l'écart au repos entre les deux éléments supports 12 et 13. Ces fils déterminent l'étirement maximal de la zone active et forment, comme dans les modes de réalisation précédents, des éléments limiteurs de déformation hors du plan de la zone active. Les éléments support peuvent être des fils de trame du tissu.

Les différentes variantes sont bien entendu combinables.

On notera que la mise en oeuvre de l'invention ne requiert aucune modification de la structure active en elle-même.

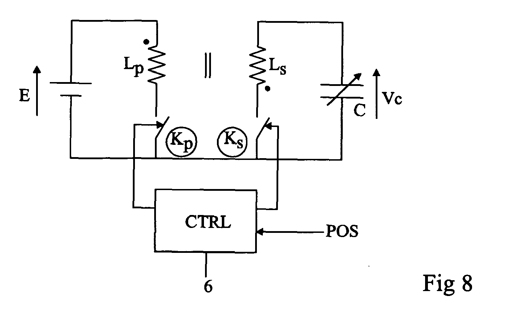

La figure 8 est un schéma électrique simplifié du système de récupération d'énergie. Cet exemple est un convertisseur continu-continu de type indirect (flyback). La capacité variable C formée par la membrane active 11 est connectée, par un interrupteur Ks, à l'enroulement secondaire Ls d'un transformateur. L'enroulement primaire Lp du transformateur est connecté, par un interrupteur Kp, aux bornes d'une source de tension E servant de source de stockage. Les points de phase des enroulements Lp et Ls sont inversés. Les interrupteurs Kp et Ks sont commandés par un circuit 6 synchronisant leurs périodes de fermeture en fonction de la position de la structure. Cette position est par exemple fournie au circuit 6 sous la forme d'un signal de position POS à deux états obtenus par détection de la position étirée/rétractée de la membrane. Par exemple, on détecte les valeurs de la capacité (minimale et maximale) du circuit pour en déduire l'état étiré ou comprimé de la partie active. Pour charger la capacité variable C, l'interrupteur Kp est fermé (interrupteur Ks ouvert) jusqu'à ce que le circuit magnétique alimenté par la source de tension E soit entièrement chargé. L'ouverture de l'interrupteur Kp et la fermeture de l'interrupteur Ks permettent le transfert de l'énergie du circuit magnétique dans la capacité variable C formée par la zone active. La structure se charge sous sa capacité maximale. Les deux interrupteurs sont alors ouverts pour que la phase de récupération commence. La structure (capacité C) bouge mécaniquement et sa capacité varie passant, par exemple, d'une valeur maximale à une valeur minimale. Pour décharger la capacité, l'interrupteur Ks est fermé suffisamment longtemps pour que l'énergie soit transférée au circuit magnétique. Enfin, on ouvre l'interrupteur Ks et on ferme l'interrupteur Kp pour que cette énergie soit transférée à l'unité de stockage E. La synchronisation du cycle d'acquisition d'énergie doit être effectuée sur les mouvements mécaniques de la structure, une telle synchronisation étant en elle-même usuelle. Selon les applications, l'énergie récupérée est stockée dans un élément de type batterie ou condensateur ou produite lorsque l'application en a besoin.

Un même circuit de commande et de transfert peut le cas échéant gérer plusieurs structures, par exemple, plusieurs membranes 11 empilées et liées à un même support.

D'autres circuits usuels de commande et de transfert peuvent être utilisés, l'invention n'intervenant que sur la structure de liaison du transducteur à son support.

La mise en oeuvre pratique de l'invention est à la portée de l'homme de métier à partir des indications fonctionnelles données ci-dessus. En particulier, le choix des matériaux utilisés pour former les éléments limiteurs dépend de l'application et notamment de l'objet portant la structure (tissu, objet autonome, etc.). De plus, le choix de la forme de l'élément limiteur entre un serpentin à méandres rectangulaires ou arrondis dépend de l'application et des structures disponibles. Par ailleurs, le choix des moyens de fixation et de liaison est à la portée de l'homme du métier en fonction de l'application, par exemple en utilisant le même type de moyen que dans les liaisons support-membrane. Enfin, bien que l'invention ait été décrite en relation avec plusieurs éléments limiteurs entre les deux supports de la membrane, on pourra prévoir un seul élément limiteur, de préférence alors centré entre les deux supports.

## Revendications

1. Transducteur à polymère électroactif comportant :
une membrane (11) formée d'une portion approximativement rectangulaire en polymère électroactif entre deux électrodes parallèles, au moins deux points de la membrane (11) étant reliés à des supports rigides (12, 13 ; 12', 13' ; 41, 42, 43, 44 ; 12, 13), maintenant le polymère électroactif dans un plan et adaptés à transmettre une contrainte mécanique selon une direction de déformation privilégiée dans ce plan ; et
au moins un élément limiteur (21, 22 ; 21, 22 ; 21, 22, 23, 24 ; 51, 52, 53, 54, 55, 56, 57) reliant les supports et ayant une forme de serpentin, l'élément limiteur limitant la déformation de la membrane selon la direction de déformation privilégiée et étant lié à la membrane en plusieurs points approximativement répartis.

2. Transducteur selon la revendication 1, dans lequel les électrodes (112, 113) prennent la membrane (111) en sandwich.

3. Transducteur selon la revendication 1, dans lequel les électrodes (112, 113) sont d'un même côté de la membrane (111).

4. Transducteur selon l'une quelconque des revendications 1 à 3, dans lequel l'élément limiteur (21, 22 ; 21, 22 ; 21, 22, 23, 24 ; 51, 52, 53, 54, 55, 56, 57) subit des déformations non coplanaires aux déformations de la membrane (11).

5. Transducteur selon l'une quelconque des revendications 1 à 4, dans lequel deux supports (12, 13 ; 12', 13' ; 12, 13) sont dans le plan de la membrane (11) et sont approximativement perpendiculaires à l'élément limiteur (21, 22 ; 21, 22 ; 51, 52, 53, 54, 55, 56, 57).

6. Transducteur selon l'une quelconque des revendications 1 à 5, dans lequel la membrane (11) est encadrée par une zone (18) non active.

7. Transducteur selon la revendication 6, dans lequel ladite zone (18) n'est pas déformable dans la direction de déformation de la membrane (11).

8. Transducteur selon l'une quelconque des revendications 1 à 7, comportant plusieurs éléments limiteurs (21, 22 ; 21, 22 ; 21, 22, 23, 24 ; 51, 52, 53, 54, 55, 56, 57) parallèles entre eux.

9. Transducteur selon la revendication 8, dans lequel les serpentins formés par les éléments limiteurs (21, 22 ; 21, 22 ; 21, 22, 23, 24 ; 51, 52, 53, 54, 55, 56, 57) sont dans des plans perpendiculaires au plan de la membrane (11).

10. Transducteur selon la revendication 8 ou 9, dans lequel les éléments limiteurs (21, 22 ; 21, 22 ; 21, 22, 23, 24) et les supports (12, 13 ; 12', 13' ; 41, 42, 43, 44) sont une seule et même pièce formant un cadre autour de la membrane (11).

11. Transducteur selon l'une quelconque des revendications 1 à 9, dans lequel plusieurs membranes sont superposées et partagent de mêmes supports et éléments limiteurs.

12. Transducteur selon l'une quelconque des revendications 1 à 11, dans lequel l'élongation du serpentin est limitée par des éléments de butée.

13. Système de récupération d'énergie d'un étirement mécanique, **caractérisé en ce qu'**il comporte au moins un transducteur conforme à l'une quelconque des revendications précédentes et un circuit électronique (2) de gestion de la charge et de la décharge du transducteur.

14. Système actionneur comportant un circuit électronique de génération d'un champ électrique et au moins un transducteur conforme à l'une quelconque des revendications précédentes.

## Claims

1. An electroactive polymer transducer comprising:
a membrane (11) formed of an approximately rectangular electroactive polymer portion between two parallel electrodes, at least two points of the membrane (11) being connected to rigid supports (12, 13; 12', 13'; 41, 42, 43, 44; 12, 13) maintaining the electroactive polymer in a plane and adapted to transmit a mechanical constraint along a privileged deformation direction in this plane; and
at least one limiting element (21, 22; 21, 22; 21, 22, 23, 24; 51, 52, 53, 54, 55, 56, 57) connecting the supports and having a meandering shape, the limiting element limiting the deformations of the membrane along the privileged deformation direction and being connected to the membrane at several approximately distributed points.

2. The transducer of claim 1, wherein the electrodes (112, 113) sandwich the membrane (111).

3. The transducer of claim 1, wherein the electrodes (112, 113) are on a same side of the membrane (111).

4. The transducer of any of claims 1 to 3, wherein the limiting element (21, 22; 21, 22; 21, 22, 23, 24; 51, 52, 53, 54, 55, 56, 57) undergoes deformations non coplanar to the deformations of the membrane (11).

5. The transducer of any of claims 1 to 4, wherein two supports (12, 13; 12', 13'; 12, 13) are in the plane of the membrane (11) and are approximately perpendicular to the limiting element (21, 22; 21, 22; 51, 52, 53, 54, 55, 56, 57).

6. The transducer of any of claims 1 to 5, wherein the membrane (11) is surrounded by a non-active area (18).

7. The transducer of claim 6, wherein said area (18) is not deformable in the deformation direction of the membrane (11).

8. The transducer of any of claims 1 to 7, comprising several parallel limiting elements (21, 22; 21, 22; 21, 22, 23, 24; 51, 52, 53, 54, 55, 56, 57).

9. The transducer of claim 8, wherein the meanders formed by the limiting elements (21, 22; 21, 22; 21, 22, 23, 24; 51, 52, 53, 54, 55, 56, 57) are in planes perpendicular to the plane of the membrane (11).

10. The transducer of claim 8 or 9, wherein the limiting elements (21, 22; 21, 22; 21, 22, 23, 24) and the supports (12, 13; 12', 13'; 41, 42, 43, 44) are one and the same part forming a frame around the membrane (11).

11. The transducer of any of claims 1 to 9, wherein several membranes are superposed and share same supports and limiting elements.

12. The transducer of any of claims 1 to 11, wherein the elongation of the meandering shape is limited by stop elements.

13. A system for recovering power from a mechanical stretching, comprising at least one transducer of any of the foregoing claims and one electronic circuit (2) for managing the charge and the discharge of the transducer.

14. An actuator system comprising an electronic circuit for generating an electric field and at least one transducer of the foregoing claims.

## Patentansprüche

1. Ein Wandler mit elektroaktivem Polymer, der Folgendes aufweist:
eine Membran (11), die aus einem annähernd rechteckigen elektroaktiven Polymerteil zwischen zwei parallelen Elektroden gebildet ist, wobei wenigstens zwei Punkte der Membran (11) mit festen Trägern (12, 13; 12', 13'; 41, 42, 43, 44; 12, 13) verbunden sind, die das elektroaktive Polymer in einer Ebene halten und geeignet sind eine mechanische Kraft beziehungsweise ein mechanisches Zusammenziehen entlang einer bevorzugten Verformungsrichtung in dieser Ebene zu übertragen; und
wenigstens ein begrenzendes Element (21, 22; 21, 22; 21, 22, 23, 24; 51, 52, 53, 54, 55, 56, 57), das die Träger verbindet und eine mäanderform aufweist, wobei das begrenzende Element die Verformungen der Membran entlang der bevorzugten Verformungsrichtung begrenzt und mit der Membran an mehreren annähernd verteilten Punkten verbunden ist.

2. Der Wandler nach Anspruch 1, wobei die Membran (111) zwischen den Elektroden (112, 113) sandwichartig angeordnet ist.

3. Der Wandler nach Anspruch 1, wobei die Elektroden (112, 113) auf einer selben Seite der Membran (111) sind.

4. Der Wandler nach einem der Ansprüche 1 bis 3, wobei das begrenzende Element (21, 22; 21, 22; 21, 22, 23, 24; 51, 52, 53, 54, 55, 56, 57) Verformungen unterliegt, die nicht koplanar zu den Verformungen der Membran (11) sind.

5. Der Wandler nach einem der Ansprüche 1 bis 4, wobei zwei Träger (12, 13; 12', 13'; 12, 13) in der Ebene der Membran (11) liegen und annähernd senkrecht zu dem begrenzenden Element (21, 22; 21, 22; 51, 52, 53, 54, 55, 56, 57) sind.

6. Der Wandler nach einem der Ansprüche 1 bis 5, wobei die Membran (11) von einem nicht aktiven Bereich (18) umgeben ist.

7. Der Wandler nach Anspruch 6, wobei der Bereich (18) nicht in der Verformungsrichtung der Membran (11) verformbar ist.

8. Der Wandler nach einem der Ansprüche 1 bis 7, wobei der Wandler mehrere parallele begrenzende Elemente (21, 22; 21, 22; 21, 22, 23, 24; 51, 52, 53, 54, 55, 56, 57) aufweist.

9. Der Wandler nach Anspruch 8, wobei die Mäander, die durch die begrenzenden Elemente (21, 22; 21, 22; 21, 22, 23, 24; 51, 52, 53, 54, 55, 56, 57) gebildet werden in Ebenen liegen, die senkrecht zu der Ebene der Membran (11) sind.

10. Der Wandler nach Anspruch 8 oder 9, wobei die begrenzenden Elemente (21, 22; 21, 22; 21, 22, 23, 24) und die Träger (12, 13; 12', 13'; 41, 42, 43, 44) ein und dasselbe Teil sind, die einen Rahmen um die Membran (11) bilden.

11. Der Wandler nach einem der Ansprüche 1 bis 9, wobei mehrere Membrane überlagert sind und sich dieselben Träger und begrenzenden Elemente teilen.

12. Der Wandler nach einem der Ansprüche 1 bis 11, wobei die Ausdehnung der mäanderform durch Stoppelemente begrenzt ist.

13. Ein System zur Rückgewinnung von Energie aus einer mechanischen Dehnung, wobei das System wenigstens einen Wandler nach einem der vorhergehenden Ansprüche aufweist und einen elektronischen Schaltkreis (2) zum Steuern der Ladung und der Entladung des Wandlers.

14. Ein Betätigungssystem, das einen elektronischen Schaltkreis zum Erzeugen eines elektrischen Feldes und wenigstens einen Wandler nach einem der vorhergehenden Ansprüche aufweist.
